# DEMANDE DE BREVET EUROPEEN

(11) **EP 0 525 715 A1**
(43) Date de publication de la demande: **03.02.1993**
(21) Numéro de dépôt: 92112846.8
(22) Date de dépôt: 28.07.1992
(51) Int. Cl.: H05K 7/14

(54) **Procédé de codage associatif de cartes de circuit imprimé et dispositif pour la mise en oeuvre de ce procédé**

(30) Priorité: 30.07.1991 FR 9109659
(71) Demandeur: ALCATEL CIT, F-75008 Paris (FR)
(72) Inventeur: Le Goe, Gérard, F-91620 La Ville du Bois (FR); Roger, Jacques, F-78280 Guyancourt (FR)
(74) Mandataire: Weinmiller, Jürgen

(57) **Abrégé**

Le dispositif selon l'invention comprend une pièce de codage (20) composée d'un longeron central, de bras d'accrochage (24) et d'une série d'appendices (25) dont l'espacement mutuel correspond à l'écartement entre deux glissières (32) de guidage des cartes (7). La face avant (18) de chaque carte porte une lumière de codage (31), permettant le passage d'un appendice (25) lorsque celui-ci est placé en regard de cette lumière (31). La position de la lumière de codage (31) constitue une caractéristique commune de toutes les cartes (7) d'une famille donnée. Après mise en place, dans le châssis, d'une première carte (7), seules d'autres cartes de la même famille peuvent être connectées dans la partie du châssis munie de la pièce de codage (20). On élimine ainsi le risque de mise en place, dans un même châssis (ou compartiment de châssis) de cartes de familles différentes et incompatibles entre elles, bien que correspondant à un même type de produit et ayant la même fonctionnalité.

## Description

La présente invention concerne un procédé de codage associatif de cartes de circuit imprimé, destinées à être connectées dans un châssis pouvant être monté dans une armoire ou un bâti, en étant guidées chacune au moyen de glissières faisant partie d'une pluralité de glissières disposées parallèlement entre elles, perpendiculairement au fond de panier du châssis, chacune de ces cartes comportant une face avant, constituée par une paroi perpendiculaire à son plan, destinée à fermer une partie d'une face frontale ouverte du châssis lorsque la carte est placée dans celui-ci. L'invention concerne également un dispositif pour la mise en oeuvre de ce procédé.

Ce procédé peut notamment être mis en oeuvre pour supprimer le risque de mise en place incorrecte des cartes dans un châssis de type normalisé, faisant partie d'une armoire ou d'un bâti pour une installation de télécommunication. Plus particulièrement, l'invention a pour but d'éliminer le risque de mise en place dans un même châssis de cartes de familles différentes et incompatibles entre elles, bien qu'appartenant a un même type de produit et ayant la même fonctionnalité.

Les armoires ou bâtis utilisés dans les installations de télécommunication comprennent, chacune, un certain nombre de châssis de forme paralélépi- pédique et de dimensions normalisées, présentant une paroi arrière, dite "fond de panier", constituée par une plaque portant un circuit imprimé, cette plaque supportant des éléments de connecteur multibroches destinés à recevoir des éléments de connecteur correspondants portés chacun par une carte de circuit imprimé et raccordés aux circuits de cette carte, la face avant du châssis en regard du fond de panier étant ouverte pour permettre de placer, de manière amovible, une pluralité de cartes, disposées parallèlement entre elles, selon un plan vertical perpendiculaire au fond de panier, chacune de ces cartes devant être placée en un emplacement bien déterminé du châssis afin que soit assuré non seulement un couplage mécanique correct, mais encore le couplage électrique assurant les liaisons nécessaires entre le circuit du fond de panier et celui de la carte. Pour assurer le guidage des cartes lors de leur mise en place, afin de mettre les éléments de connecteur portés par les cartes exactement en regard des éléments de connecteurs correspondants fixés sur le fond de panier, le châssis est muni de glissières perpendiculaires au fond de panier et parallèles entre elles.

Chaque carte de circuit imprimé présente un panneau perpendiculaire à son plan principal, fixé sur le bord de la carte parallèle à celui qui porte le (ou les) élément(s) de connecteur destiné(s) à être enfiché(s) avec le (ou les) élément(s) de connecteur correspondant(s) fixé(s) sur le fond de panier, ce panneau étant désigné par le terme de "face avant" de la carte. Cette face avant qui est tournée du côté de l'ouverture du châssis pendant et après la mise en place de la carte dans celui-ci, peut porter des indications concernant l'emplacement correct de la carte dans le châssis. Toutefois, il existe néanmoins un certain risque de lecture ou d'interprétation erronée de ces indications, ou encore d'erreur de manipulation subséquente à cette lecture, pouvant conduire à une mise en place incorrecte des cartes dans le châssis.

C'est pourquoi, afin d'éliminer le risque d'erreur dans la mise en place individuelle de chaque carte, on met en oeuvre, de manière connue en soi, un procédé de codage individuel selon lequel on utilise pour chaque carte, d'une part, une pièce de codage fixée sur, ou faisant partie intégrante de, au moins un élément de connecteur fixé sur le fond de panier et, d'autre part, une pièce de codage correspondante fixée sur, ou faisant partie intégrante de, au moins un élément de connecteur fixé sur la carte, ces deux pièces de codage étant rendues sélectivement enfichables l'une dans l'autre grâce à un codage réalisé, par exemple, par obstruction au moyen de clés amovibles (dites "clés de détrompage") d'ouvertures prédéterminées faisant partie d'une série d'ouvertures identiques dans l'une des pièces et enlèvement dans l'autre pièce, en position correspondant à la position des ouvertures fermées par les clés de détrompage, de parties saillantes faisant partie d'une série de parties destinées à pénétrer dans les ouvertures de cette série.

L'adaptation de ce procédé de codage individuel à la discrimination entre des familles différentes de cartes appartenant à un même type de produit et ayant la même fonctionnalité, mais néanmoins incompatibles entre elles, c'est-à-dire correspondant à des versions techniques et/ou électriques différentes (par exemple, d'une part, des cartes de technologie ECL et, d'autre part, des cartes de technologie CMOS) présenterait l'inconvénient de nécessiter une modification du codage de tous les éléments de connecteur fixés sur le fond de panier, avec pour conséquence la suppression de la possibilité d'utiliser, de manière interchangeable, des familles différentes de cartes dans un châssis donné, à moins de modifier à nouveau le codage de tous les éléments de connecteur du fond de panier, ce qui constituerait une opération relativement longue et fastidieuse, tout en entraînant un nouveau risque d'erreur non négligeable.

L'invention a précisément pour but d'obvier à l'inconvénient qui vient d'être mentionné, en permettant un codage associatif des cartes selon la famille à laquelle elles appartiennent, en conservant ainsi l'interchangeabilité des cartes, mais par famille complète, sans modification du codage individuel des éléments de connecteur fixés sur le fond de panier, pas plus que de celui des éléments de connecteur fixés sur les cartes.

A cet effet, le procédé de codage,selon l'invention, est caractérisé en ce que l'on installe dans le châssis, préalablement à la mise en place de la première carte, au moins une pièce de codage allongée munie d'une série d'organes en saillie disposés perpendiculairement à la longueur de cette pièce, à intervalles déterminés en correspondance avec les intervalles déterminés respectifs entre deux glissières consécutives, chacun de ces organes étant agencés de façon à collaborer, par association du type "mâle-femelle" avec une ouverture ménagée dans la face avant de chaque carte, pour ne permettre la connexion de cette carte que dans le cas où elle appartient à une même famille que la première carte montée et connectée dans le châssis, ladite pièce de codage étant placée parallèlement au plan de la face frontale ouverte du châssis et étant susceptible d'être déplacée longitudinalement pour assurer la mise en place de la première carte de la famille, le codage des cartes d'une même famille étant défini par l'emplacement de ladite ouverture dans le plan de la face avant de chaque carte.

Le dispositif pour la mise en oeuvre de ce procédé est caractérisé en ce qu'il comprend au moins une pièce de codage associatif consistant en une pièce de forme allongée munie de moyens pour monter cette pièce à l'intérieur du châssis et comportant une pluralité d'organes en saillie s'étendant perpendiculairement à la longueur de la pièce de codage, parallèlement entre eux, et en étant disposés à intervalles déterminés en correspondance avec les intervalles déterminés respectifs entre deux glissières de guidage consécutives.

Conformément à une première forme d'exécution de ce dispositif, adapté à l'utilisation dans le cas particulier où les glissières de guidage des cartes de circuit imprimé sont disposées à intervalle constant entre elles, lesdits organes en saillie sont également disposés à intervalle constant, égal à l'intervalle entre deux glissières de guidage consécutives.

Conformément à une autre forme d'exécution de ce dispositif adapté à l'utilisation dans le cas où les intervalles entre les glissières de guidage des cartes correspondent à au moins deux valeurs différentes, chacun de ces intervalles étant égal à une valeur prédéterminée ou correspondant à un multiple entier de cette valeur, lesdits organes en saillie sont séparés par un intervalle égal à ladite valeur prédéterminée de l'intervalle entre les glissières de guidage ou par un intervalle correspondant à un multiple entier de cette valeur.

L'invention sera bien comprise grâce à la description détaillée, qui va suivre, d'une forme d'exécution particulière d'un dispositif permettant la mise en oeuvre du procédé selon l'invention, cette description étant faite à titre d'exemple non limitatif, en se référant au dessin annexé, dans lequel:
La Fig. 1 est une vue en perspective, partiellement éclatée, d'un châssis pouvant être monté dans une armoire ou un bâti et être équipé du dispositif de codage associatif de cartes selon l'invention;
La Fig. 2 est une vue en perspective d'un premier élément de connecteur multibroches, fixé sur le fond de panier du châssis illustré à la Fig. 1, ainsi que d'une partie d'une carte de circuit imprimé portant un deuxième élément de connecteur destiné à être raccordé avec ledit premier élément, chacun de ces deux éléments de connecteur étant muni d'une pièce de codage individuel de carte faisant partie d'un dispositif de codage de type connu;
La Fig. 3 est une vue en élévation latérale de l'ensemble d'une carte de circuit imprimé telle que celle dont une partie est représentée à la Fig. 2, portant deux éléments de connecteur dont l'un est muni d'une pièce de codage ainsi que d'un support de face avant et de deux verrous destinés à fixer cette carte après sa mise en place dans le châssis représenté à la Fig. 1;
La Fig. 4 est une vue en perspective, partiellement déchirée, d'une pièce de codage associatif de carte, conformément à une forme d'exécution du dispositif selon l'invention;
La Fig. 5 est une vue en plan de la pièce de codage illustrée à la Fig. 4;
La Fig. 6 est une vue en coupe transversale schématique d'un profilé faisant partie du châssis illustré à la Fig. 1, muni de la pièce de codage illustrée aux Figures 4 et 5; et
La Fig. 7 est une vue en plan montrant le positionnement d'une carte de circuit imprimé, munie du dispositif de codage selon l'invention, dans le châssis de la Fig. 1 muni de la pièce de codage illustrée aux Figures 4, 5 et 6.

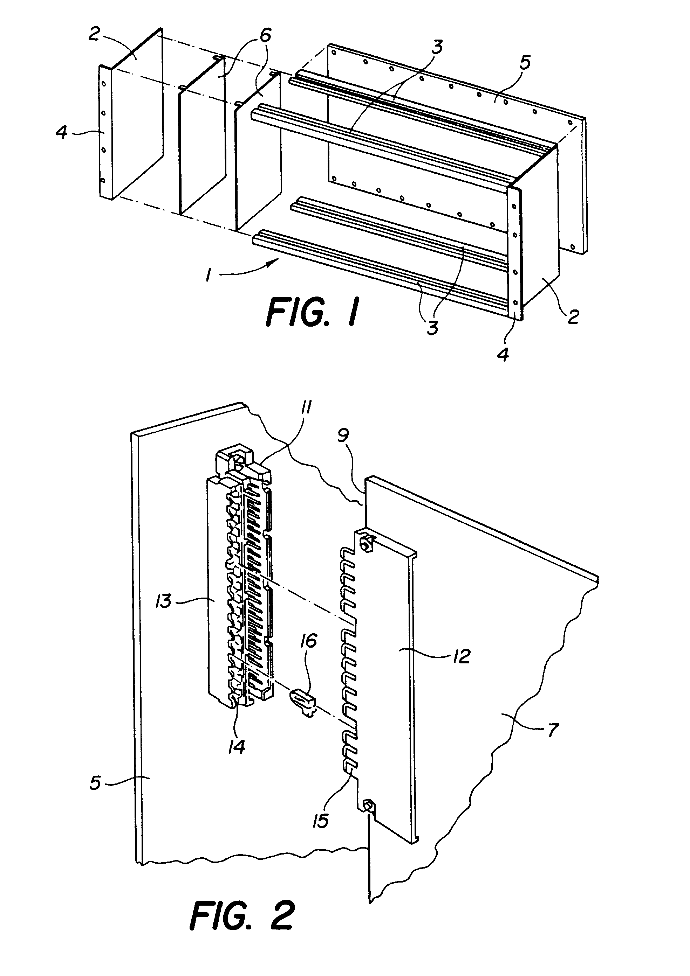

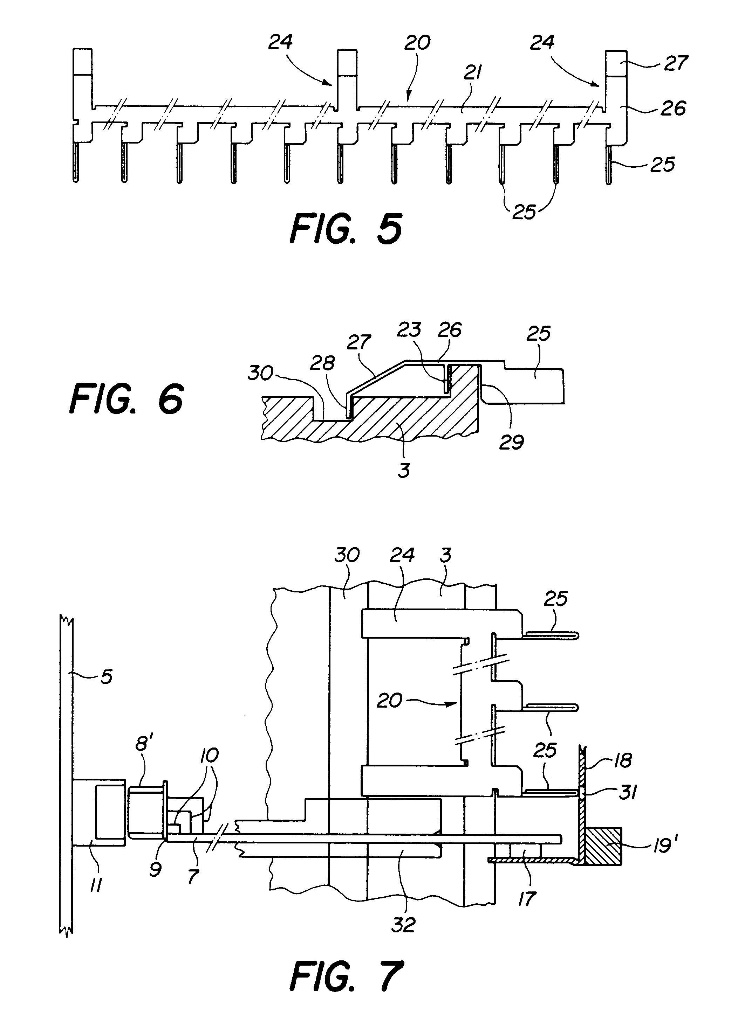

Comme on le voit à la Fig. 1, le châssis 1, qui est avantageusement réalisé en métal, par exemple en aluminium, est composé de deux flasques latéraux 2, symétriques, reliés entre eux par quatre profilés 3, dont la section comprend essentiellement une partie en forme de T (dont la forme apparaît également d'après la Fig. 6). Le bord antérieur des flasques 2 présente un rebord 4 replié à angle droit afin de permettre la fixation du châssis 1 sur les montants de l'armoire ou du bâti (non représentés). L'arrière du châssis 1 est fermé par une paroi qui constitue un fond de panier 5 portant un circuit imprimé. Des cloisons intérieures 6 subdivisent l'intérieur du châssis 1 en plusieurs compartiments. Des glissières (telles que la glissière inférieure 17 représentée à la Fig. 7,) pour le guidage de cartes de circuit imprimé (celles-ci étant posées sur la tranche dans un plan parallèle à celui des flasques latéraux 2 et des cloisons intérieures 6) sont fixées sur les profilés 3 inférieurs et supérieurs en regard l'une de l'autre deux à deux.

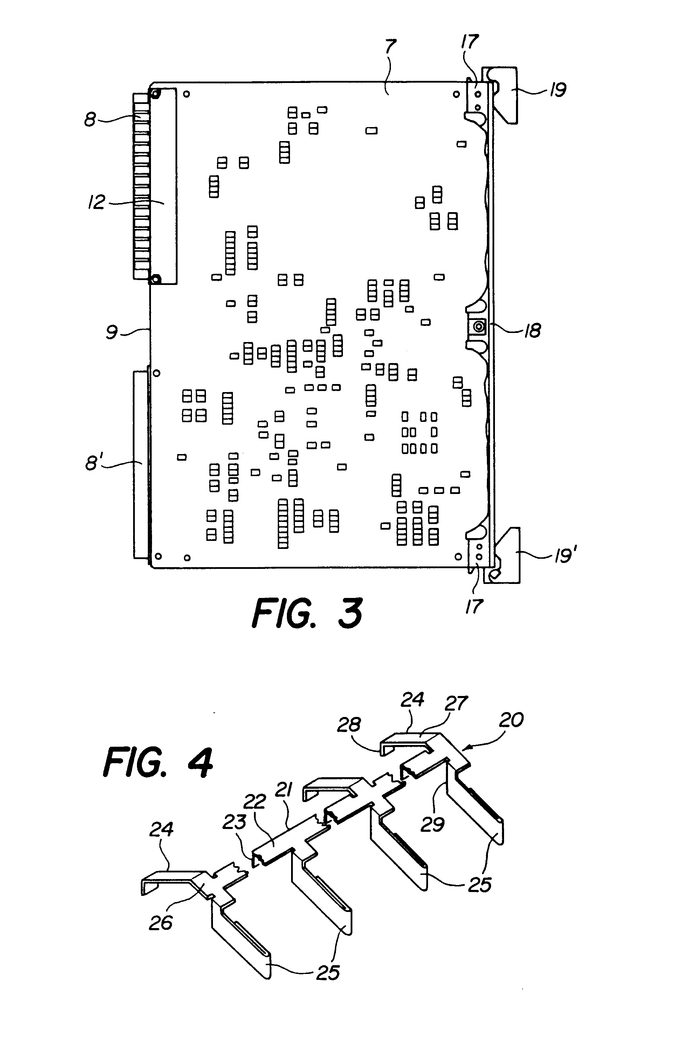

Chaque carte de circuit imprimé 7 perte au moins un élément mâle de connecteur 8-8' (Figures 3 et 7), fixé sur le bord postérieur 9 de la carte 7 et relié au circuit de cette carte au moyen d'une pluralité de connexions 10 (Fig. 7). Comme représenté sur cette dernière figure, chaque élément de connecteur 8' est enfichable dans un élément femelle de connecteur 11 correspondant fixé sur le fond de panier 5 et visible en perspective sur la figure 2.

Selon cette figure 2, une pièce de codage mâle 12 est fixée sur le bord postérieur 9 de la carte 7, sur la face de cette dernière opposée à celle qui porte l'élément mâle de connecteur 8, cette pièce de codage 12 étant disposée exactement en regard de l'élément mâle de connecteur 8 (Fig. 3).

Une pièce de codage 13, venue de moulage avec l'élément de connecteur 11 (cette pièce de codage 13 pouvant toutefois être, en variante, fixée sur l'élément 11 sans faire partie intégrante de celui-ci), comprend une série de cavités identiques 14, numérotées, agencées de manière à permettre l'insertion de languettes 15 faisant partie d'une série de languettes numérotées de manière correspondante à la numérotation des cavités 14, faisant saillie à partir du bord de la pièce de codage mâle 12 tournée vers l'extérieur de la carte 7.

Comme on le voit à la Fig. 2, le codage individuel de la carte 7, pour ne permettre l'enfichage de l'élément mâle 8 de connecteur que dans l'élément femelle 11 de connecteur qui lui est destiné, est effectué en obturant un certain nombre de cavités 14 (ce nombre étant généralement un ou deux) au moyen de clés de détrompage 16 agencées de manière à pouvoir être aisément mises en place ou retirées des cavités 14 et à être retenues par clipsage dans ces cavités, tout en étant bien visibles grâce à un contraste de couleur, avec la pièce de codage femelle 13, la ou les languettes 15 de la pièce de codage mâle 12 correspondant aux cavités 14 obturées par les clés de détrompage ayant été enlevées, par cassure, afin de permettre l'insertion sélective des autres languettes 15 dans les cavités 14 restées ouvertes.

La carte 7, représentée dans son ensemble à la Fig. 3, est équipée de deux éléments mâles de connecteur 8 et 8', fixés sur la face de la carte 7 portant les composants actifs ou non actifs. Seul l'élément de connecteur 8 fixé sur la partie supérieure du bord arrière 9 de la carte 7 est muni d'une pièce de codage mâle 12, étant bien entendu que l'autre élément de connecteur 8' pourrait également être muni d'une telle pièce de codage (ou même, que seul l'élément 8' pourrait être muni d'une pièce de codage).

La partie antérieure de la carte 7 est fixée à un support de face avant 17 sur lequel la face avant 18 de la carte est elle-même fixée. Deux verrous 19 et 19' peuvent être repliés contre la face avant 18 de la carte 7, afin de verrouiller la carte 7 dans le châssis 1, après la mise en place de celle-ci et insertion complète des éléments mâles 8 et 8' de connecteur dans des compartiments récepteurs ménagés pour les recevoir dans les éléments femelles 11 de connecteur correspondants.

Après avoir ainsi décrit l'agencement du châssis 1 et d'une carte de circuit 7 équipés, de manière connue en soi, d'un dispositif de codage individuel des cartes, on va maintenant décrire le procédé et le dispositif de codage associatif qui font l'objet de la présente invention.

Les Figures 4 et 5 représentent une pièce de codage associatif 20 utilisée pour la mise en oeuvre du procédé selon l'invention. Cette pièce de codage 20 est avantageusement réalisée à partir d'une tôle métallique, de préférence une tôle d'acier inoxydable. Elle pourrait cependant être également réalisée en matière plastique rigide.

La pièce 20 se compose d'un longeron central 21, constitué par un profité en L, ayant une face supérieure 22 et un rebord 23 replié à angle droit vers le bas par rapport à cette face supérieure 22, une pluralité de bras d'accrochage 24 (au nombre de trois, selon la forme d'exécution illustrée au dessin) et d'une pluralité d'appendices 25 s étendant perpendiculairement au longeron central 21 et disposés, dans le cas particulier de la forme d'exécution illustrée aux Figures 4 et 5, avec un espacement constant entre eux, et dans un plan qui, lorsque la pièce sera montée dans le châssis 1, sera parallèle à celui de chacune des cartes de circuit imprimé montées dans ledit châssis.

Les bras d'accrochage 24 se composent d'une partie horizontale 26, s étendant à partir de la face supérieure 22 du longeron 21, prolongée par une partie oblique 27, s'étendant vers le bas essentiellement en regard du rebord 23, cette partie 27 étant elle-même prolongée par un rebord 28 replié dans un plan formant, au repos (c'est-à-dire, lorsque la pièce 20 n'est soumise à aucune force de déformation agissant sur les bras 24), un faible angle, par exemple de 10" , avec le plan du rebord 23, le rebord 28 se rapprochant du rebord 23.

La partie proche postérieure de chaque appendice 25, qui prend naissance sous l'extrémité de la face supérieure 22, forme un bord vertical 29 parallèle au plan du rebord 23, et séparé de celui-ci par un espace correspondant à l'épaisseur du bord supérieur du profilé 3, de sorte que la pièce 20 peut être montée sur ce profilé, dans la position illustrée en coupe à la Fig. 6. Le maintien de la pièce 20 sur le profilé 3 est assuré grâce à l'élasticité des bras d'accrochage 24, dont le rebord le plus éloigné 28 s'appuie sur une paroi latérale verticale d'une rainure 30 pratiquée dans le profilé 3 avec une certaine force élastique assurant un coincement de la pièce 20 sur le profilé 3. Ainsi, la pièce 20 est fixée sur le profilé 3 sans aucun moyen de fixation (tel qu'une vis) distinct de cette pièce elle-même, et elle peut être mise en place sur le profilé 3, ou enlevée de celui-ci, de manière instantanée et sans aucun outillage. En outre, la pièce 20 peut être simplement déplacée longitudinalement en glissant sur le profilé 3, une fois mise en place sur ce dernier.

La pièce 20 peut être facilement réalisée à partir d'une tôle métallique, telle qu'une tôle d'acier inoxydable, par emboutissage et pliage à la presse, ce qui permet sa production à l'échelle industrielle avec un faible coût de revient. Comme on le voit le mieux à la Fig. 4, les appendices 25 sont réalisés en repliant la tôle sur elle-même, ce qui leur confère une grande rigidité qui est souhaitable pour assurer convenablement leur fonction, qui sera mieux comprise grâce à la suite de la description.

Comme on le voit à la Fig. 7, la face avant 18 de chaque carte 7 présente une fente ou lumière de codage 31, permettant le passage d'un appendice 25 lorsque ce dernier est placé en regard de cette lumière de codage 31. Le codage associatif des cartes 7 appartenant à une même famille (comme défini précédemment) s'effectue en conférant la même position (telle que repérée par rapport au plan de la carte 7) à la lumière de codage 31 sur la face avant 18 de toutes les cartes 7 d'une même famille et, par conséquent, en conférant une position différente à cette lumière de codage pour des cartes 7 appartenant à une autre famille.

On comprend donc, comme illustré à la Fig. 7, que lorsque la position relative, dans le sens de la largeur du châssis 1, qui correspond à la longueur des profilés 3 et de la pièce de codage 20, de la glissière de guidage 32 d'une carte 7 par rapport à la pièce de codage 20, est telle qu'un appendice 25 soit en regard de la lumière 31 de la face avant de cette carte, en permettant ainsi l'enfoncement complet de l'élément mâle 8' de connecteur dans l'élément femelle 11 de connecteur correspondant, fixé sur le fond de panier 5, donc la mise en place de la carte 7 dans le châssis 1 (à un endroit qui peut être, éventuellement, déterminé grâce au dispositif de codage individuel de type connu décrit plus haut, mais non représenté à la Fig. 7), seules d'autres cartes de la même famille que la carte 7 peuvent être introduites dans le châssis 1, de part et d'autre des cloisons de séparation 6. Bien entendu, lors de la mise en place de la première carte dans le châssis, la pièce de codage devra éventuellement être déplacée le long du profilé 3, de façon à amener un appendice 25 en regard de la lumière de la face avant de cette première carte.

On peut utiliser dans chaque châssis 1, ou partie de châssis, une seule pièce de codage associatif 20, placée avantageusement sur le profilé inférieur 3 du côté de l'ouverture du châssis, mais on peut également utiliser une autre pièce de codage 20 similaire, placée sur le profilé 3 supérieur, en ménageant à la partie supérieure de la face avant 18 de chaque carte 7, une deuxième lumière en position latéralement décalée par rapport à la lumière 31, collaborant avec les appendices 25 de la pièce de codage 20 montée sur le profilé 3 supérieur, afin d'étendre les possibilités de codage des cartes.

Il est à remarquer que le dispositif de codage associatif de cartes de circuit imprimé, qui vient d'être décrit, est adapté à l'utilisation dans le cas particulier où les glissières de guidage des cartes sont disposées à intervalle constant entre elles.

Ce dispositif peut être également adapté à l'utilisation dans le cas, plus général, où les intervalles entre les glissières de guidage des cartes (et, par conséquent, également les largeurs des faces avant des cartes) correspondent à au moins deux valeurs différentes, chacun de ces intervalles étant égal à une valeur prédéterminée ou correspondant à un multiple entier de cette valeur. Il suffit, pour celà, de munir les faces avant des cartes, ayant une largeur multiple de ladite valeur prédéterminée, d'un nombre suffisant de lumières 31, ou bien de supprimer les appendices 25 inutiles.

## Revendications

1. Procédé de codage associatif de cartes de circuit imprimé, destinées à être connectées dans un châssis (1), agencé pour être équipé d'une pluralité de ces cartes, connectées alors en étant guidées chacune par au moins une glissière (32) faisant partie d'une pluralité de glissières affectées, respectivement, à ces cartes, ces glissières étant disposées parallèlement entre elles à des intervalles déterminés, chacune de ces cartes (7) comportant une face avant constituée par une paroi (18) perpendiculaire à son plan, destinée à fermer une partie d'une face frontale ouverte du châssis (1), lorsque la carte (7) est placée dans celui-ci, caractérisé en ce que l'on installe dans le châssis (1), préalablement à la mise en place de la première carte, au moins une pièce de codage allongée (20) munie d'une série d'organes en saillie (25) disposés le long de cette pièce (20), à intervalles déterminés en correspondance avec les intervalles déterminés respectifs entre deux glissières (32) consécutives, chacun de ces organes en saillie (25) étant agencé de façon à collaborer, par association du type "mâle-femelle" avec une ouverture (31) ménagée dans la face avant (18) de chaque carte (7), pour ne permettre la connexion de cette carte que dans le cas où celle-ci appartient à une même famille que la première carte montée et connectée dans le châssis (1), ladite pièce de codage (20) étant placée parallèlement au plan de la face frontale ouverte du châssis (1) et étant susceptible d'être déplacée longitudinalement pour assurer la mise en place de la première carte de la famille, le codage des cartes d'une même famille étant défini par l'emplacement de ladite ouverture (31) dans le plan de la face avant (18) de chaque carte.

2. Procédé selon la revendication 1, caractérisé en ce que les glissières (32) sont disposées à intervalle constant entre elles, et les organes en saillie (25) sont disposés à intervalle constant entre eux, égal à l'intervalle entre deux glissières (32) consécutives.

3. Procédé selon la revendication 1, caractérisé en ce que les intervalles entre les glissières (32) correspondent à au moins deux valeurs différentes, chacun de ces intervalles étant égal à une valeur prédéterminée, ou correspondant à un multiple entier de cette valeur, les organes en saillie (25) consécutifs étant séparés par un intervalle égal à ladite valeur prédéterminée de l'intervalle entre les glissières (32) ou par un intervalle correspondant à un multiple entier de cette valeur.

4. Dispositif pour la mise en oeuvre du procédé selon la revendication 1, caractérisé en ce qu'il comprend au moins une pièce de codage (20) de forme allongée, munie de moyens (23, 24, 28, 29) pour monter cette pièce à l'intérieur du châssis (1) et comportant une pluralité d'organes en saillie (25) s'étendant perpendiculairement à la longueur de la pièce de codage (20), parallèlement entre eux, et en étant disposés, à intervalles déterminés en correspondance avec les intervalles déterminés respectifs entre deux glissières de guidage (32) consécutives.

5. Dispositif selon la revendication 4, adapté à l'utilisation dans le cas où les glissières (32) sont disposées à intervalle constant entre elles, caractérisé en ce que les organes en saillie sont disposés à intervalle constant, égal à l'intervalle entre deux glissières (32) de guidage consécutives.

6. Dispositif selon la revendication 4, adapté à l'utilisation dans le cas où les intervalles entre les glissières (32) correspondent à au moins deux valeurs différentes, chacun de ces intervalles étant égal à une valeur prédéterminée ou correspondant à un multiple entier de cette valeur, caractérisé en ce que les organes en saillie (25) sont séparés par un intervalle égal à ladite valeur prédéterminée de l'intervalle entre les glissières (32), ou par un intervalle correspondant à un multiple entier de cette valeur.

7. Dispositif selon la revendication 4, caractérisé en ce que ladite pièce de codage (20) se compose d'un longeron central (21), d'une pluralité de bras d'accrochage (24), et d'une série d'appendices (25) s'étendant perpendiculairement au longeron central (21), ledit longeron central (21) et lesdits bras d'accrochage (24) étant agencés de manière à permettre le montage de la pièce de codage sur un profilé (3) disposé au voisinage d'une face frontale ouverte du châssis (1).

8. Dispositif selon la revendication 7, caractérisé en ce que lesdits appendices (25) sont constitués par des lames placées chacune dans un plan perpendiculaire à la longueur de la pièce de codage (20).

9. Dispositif selon l'une des revendications 4 à 8, caractérisé en ce que ladite pièce de codage (20) est constituée par une pièce d'un seul tenant emboutie dans une tôle métallique et conformée par pliage.
